# EUROPEAN PATENT APPLICATION

(11) **EP 3 920 111 A1**
(43) Date of publication of application: **08.12.2021**
(21) Application number: 20748419.7
(22) Date of filing: 20.01.2020
(51) Int. Cl.: G06Q 10/04, G06N 20/00

(54) **MOVEMENT ROUTE PREDICT SYSTEM, MOVEMENT ROUTE PREDICT METHOD, AND COMPUTER PROGRAM**

(30) Priority: 30.01.2019 JP 2019014351
(71) Applicant: Hitachi Information & Telecommunication Engineering, Ltd., Kanagawa 220-6122 (JP)
(72) Inventor: KITANO, Yu, Tokyo 100-8280 (JP); ASAHARA, Akinori, Tokyo 100-8280 (JP)
(74) Representative: MERH-IP Matias Erny Reichl Hoffmann Patentanwälte PartG mbB
(86) International application number: PCT/JP2020/001770
(87) International publication number: WO 2020/158488

(57) **Abstract**

A movement route of a moving body within a predetermined area is simulated. A movement route prediction system 10 includes a flow line prediction model learning unit 105 that performs machine learning on a flow line prediction model which calculates a first objective variable from a first feature amount, and a movement route prediction unit 106 that simulates a route of a moving body based on the flow line prediction model. The flow line prediction model learning unit includes a flow line data division unit 1051 that divides information on a movement route into a plurality of divisions, and a machine learning unit 1053 that performs machine learning on the flow line prediction model for each piece of the divided information on the movement route of the moving body.

## Description

### Technical Field

The present invention relates to a movement route prediction system, a movement route prediction method, and a computer program.

### Background Art

At airports, factories, or the like, it is being considered to ease congestion of facility users and improve work efficiency by changing a layout inside the facility. After changing the layout, a user measures movement routes of facility users and workers and confirms an effect of measures of the layout change. However, since the layout change is costly, it is required to reduce extra costs by estimating the effect of measures of the layout change in advance.

PTL 1 discloses a technique for predicting a flow line in a new facility layout by using a progress prediction equation calculated from facility layout information.

PTL 2 discloses a facility management system that simulates a moving object by using information recorded in a subsystem such as a check-in machine in a facility such as an airport.

### Citation List

### Patent Literature

PTL 1: JP 2014-182713 A
PTL 2: JP 2005-165676 A

### Summary of Invention

### Technical Problem

The facility management system described in PTL 2 simulates a time change of an object moving in a facility based on movement information data indicating a state of the moving object. However, since the movement information data of the facility management system is generated without including information on a destination of each moving object, it is considered that there is room for improving the accuracy of the simulation.

Therefore, the present invention has been made to solve the problem as described above, and is to improve the accuracy of a simulation for predicting a route of a moving body.

### Solution to Problem

A movement route prediction system is a system that predicts a route of a moving body moving within a predetermined area in which a plurality of checkpoints including at least one departure checkpoint, at least one target checkpoint, and at least one intermediate checkpoint is arranged, the moving body moving within the predetermined area from the departure checkpoint to the target checkpoint via the intermediate checkpoint, the system including a measurement data acquisition unit that acquires, from a movement measurement system, information on a movement route of the moving body measured by the movement measurement system, a map data input unit that acquires position information of the plurality of checkpoints, a workflow input unit that sets transit information of the plurality of checkpoints where the moving body moves, a flow line prediction model learning unit that performs machine learning on a flow line prediction model for calculating a first objective variable from a first feature amount, and a movement route prediction unit that simulates the route of the moving body based on the flow line prediction model, wherein the flow line prediction model learning unit includes a flow line data division unit that divides the information on the movement route into a plurality of divisions, and a machine learning unit that performs machine learning on the flow line prediction model for each piece of the divided information on the movement route of the moving body.

### Advantageous Effects of Invention

According to the present invention, it is possible to improve the accuracy of a simulation for predicting a route of a moving body.

### Brief Description of Drawings

[FIG. 1] FIG. 1 is a schematic diagram of a movement route prediction system of the present invention.
[FIG. 2] FIG. 2 is a schematic diagram of a hardware configuration of the movement route prediction system.
[FIG. 3] FIG. 3 is a sequence diagram of the movement route prediction system.
[FIG. 4] FIG. 4 is a measurement diagram of moving bodies.
[FIG. 5] FIG. 5 is an explanatory diagram of a flow line database and a layout database.
[FIG. 6] FIG. 6 is an explanatory diagram of a workflow database.
[FIG. 7] FIG. 7 is a diagram illustrating definition workflows in a directed graph.
[FIG. 8] FIG. 8 is a flowchart of a workflow analysis unit.
[FIG. 9] FIG. 9 is a flowchart of a definition workflow allocation unit.
[FIG. 10] FIG. 10 is a diagram illustrating flow line workflows in a directed graph.
[FIG. 11] FIG. 11 is an explanatory diagram of an update proposal presentation unit.
[FIG. 12] FIG. 12 is an explanatory diagram of a checkpoint edit box and a workflow edit box.
[FIG. 13] FIG. 13 is an explanatory diagram of an updated workflow database.
[FIG. 14] FIG. 14 is a flowchart of a flow line prediction model learning unit.
[FIG. 15] FIG. 15 is a flowchart of a flow line data analysis unit.
[FIG. 16] FIG. 16 is an explanatory diagram of the flow line data analysis unit.
[FIG. 17] FIG. 17 is an explanatory diagram of a first feature amount and a first objective variable.
[FIG. 18] FIG. 18 is an explanatory diagram of a flow line prediction model database.
[FIG. 19] FIG. 19 is a flowchart of a movement route prediction unit.
[FIG. 20] FIG. 20 is a flowchart of a virtual movement data generation unit.
[FIG. 21] FIG. 21 is a flowchart of a simulation unit.
[FIG. 22] FIG. 22 is an explanatory diagram of the movement route prediction unit.
[FIG. 23] FIG. 23 is a schematic diagram of a hardware configuration of a movement measurement system.

### Description of Embodiments

Hereinafter, one embodiment of the present invention will be described with reference to the accompanying drawings, but the present invention is not limited to the embodiment described in the drawings.

The present invention relates to a system that predicts a movement route of a moving body. That is, this system divides a route from a destination to a departure point into a plurality of sections, and simulates a flow of the moving body for each section. Note that the prediction by this system is not limited to a person, but a moving body such as a ship or a car may be predicted. The range of movement of the moving body is not limited to the inside of an airport, a factory, or the like, but may be a predetermined range of an open place such as the sea or a road. In the present embodiment, the description will be given by taking a person moving in the airport as an example.

Note that, in the present embodiment, a checkpoint indicates a stop-off point when a person moves in the airport or a passing place to which an attribute is added, flow line data indicates information on a movement route of a person, a workflow indicates transit information on a moving body between checkpoints, and a flow line simulation indicates that a movement route of a person is simulated by use of a flow line prediction model.

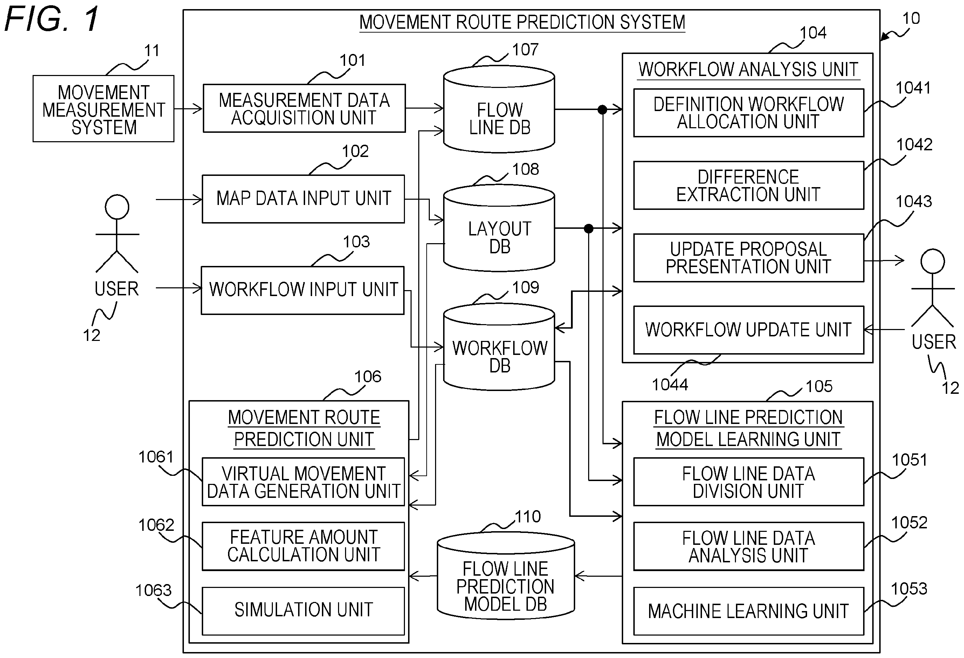

FIG. 1 is a schematic diagram of a movement route prediction system 10. The movement route prediction system 10 includes a measurement data acquisition unit 101, a map data input unit 102, a workflow input unit 103, a workflow analysis unit 104, a flow line prediction model learning unit 105, a movement route prediction unit 106, a flow line database 107, a layout database 108, a workflow database 109, and a flow line prediction model database 110.

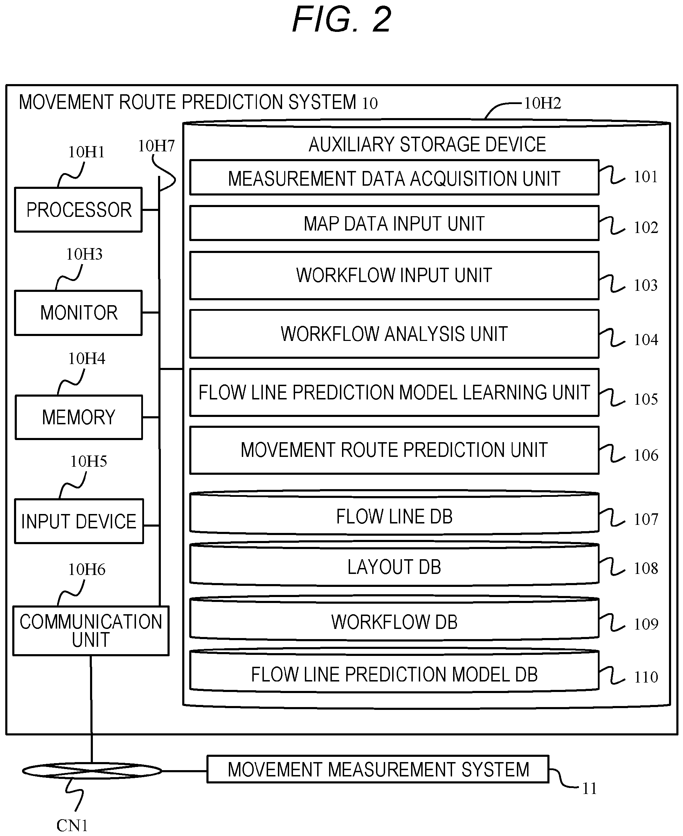

Before describing functions 101 to 110 of the movement route prediction system 10, a hardware configuration of the movement route prediction system 10 will be described. FIG. 2 is a schematic diagram illustrating the hardware configuration of the movement route prediction system 10. The movement route prediction system 10 includes a processor 10H1, an auxiliary storage device 10H2, a monitor 10H3, a memory 10H4, an input device 10H5, a communication unit 10H6, and a data transmission line 10H7 that connects the devices 10H1 to 10H6 so that the devices can communicate in both directions.

The processor 10H1 is, for example, a "central processing unit (CPU)". The processor 10H1 calls and executes, via the memory 10H4, programs 101 to 106 stored in the auxiliary storage device 10H2.

The auxiliary storage device 10H2 is, for example, a non-volatile storage device such as a hard disk or a universal serial bus (USB) memory. The auxiliary storage device 10H2 stores programs of, for example, the measurement data acquisition unit 101, the map data input unit 102, the workflow input unit 103, the workflow analysis unit 104, the flow line prediction model learning unit 105, and the movement route prediction unit 106. The auxiliary storage device 10H2 stores, for example, data structures of the flow line database 107, the layout database 108, the workflow database 109, and the flow line prediction model database 110.

The monitor 10H3 presents information to a user 12. The memory 10H4 is, for example, a volatile storage device such as a "random access memory (RAM)".

The input device 10H5 is, for example, a keyboard, a mouse, a touch panel, or the like. The user 12 operates the input device 10H5 to input data to the movement route prediction system 10. The communication unit 10H6 is, for example, a "network card (NIC)". The communication unit 10H6 is wirelessly connected to at least one movement measurement system 11 via a communication network CN1. Note that the communication unit 10H6 may be connected to the movement measurement system 11 by wired communication.

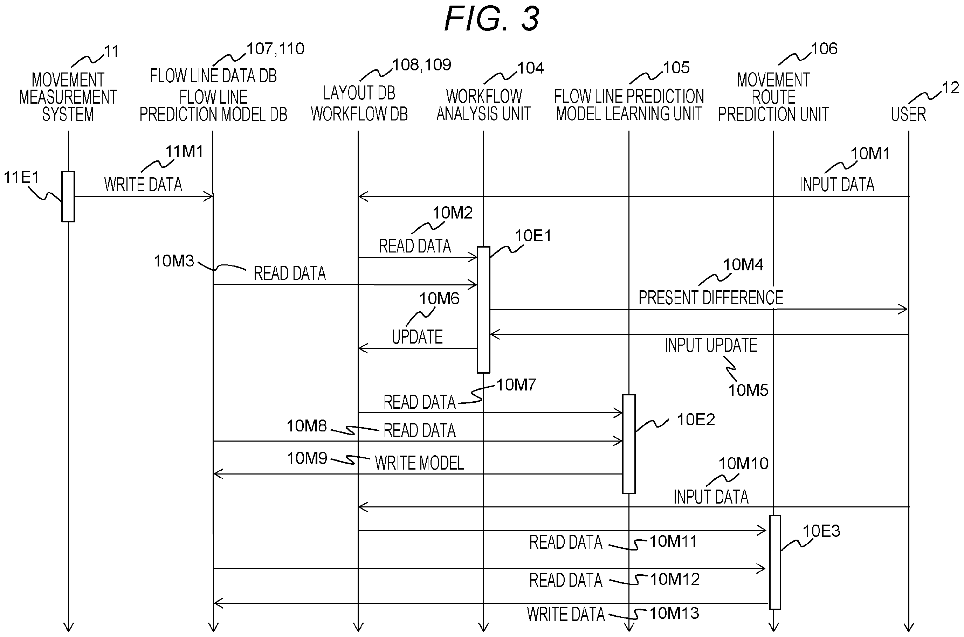

FIG. 3 is a sequence diagram of the movement route prediction system 10. A processing flow of the movement route prediction system 10 and the movement measurement system 11 will be described with reference to FIG. 1.

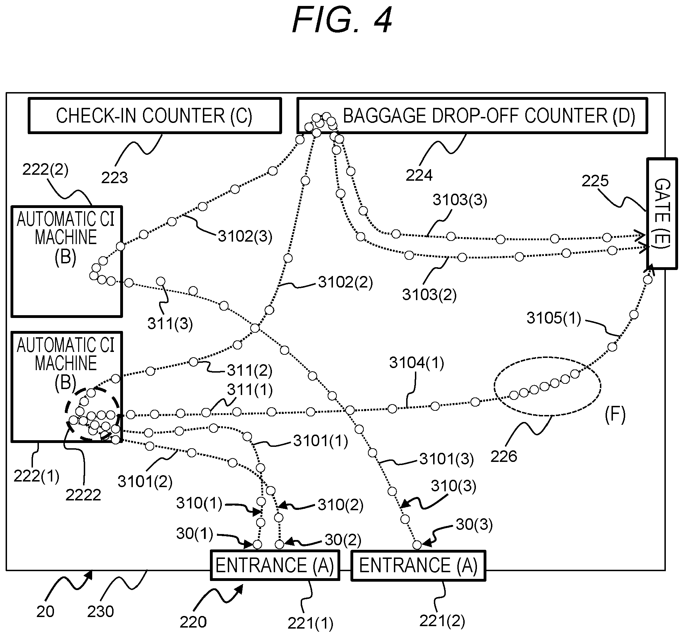

As detailed in FIG. 4, the movement measurement system 11 measures, for example, series of flow line data 310(1), 310(2), and 310(3) as examples of "information on a movement route" of persons 30(1), 30(2), and 30(3) as examples of a "moving body" moving in an airport 20 as an example of a "predetermined area" (11E1). Note that the persons 30(1), 30(2), and 30(3) may be expressed as a person 30 unless otherwise specified. The series of flow line data 310(1), 310(2), and 310(3) may be expressed as a series of flow line data 310 unless otherwise specified.

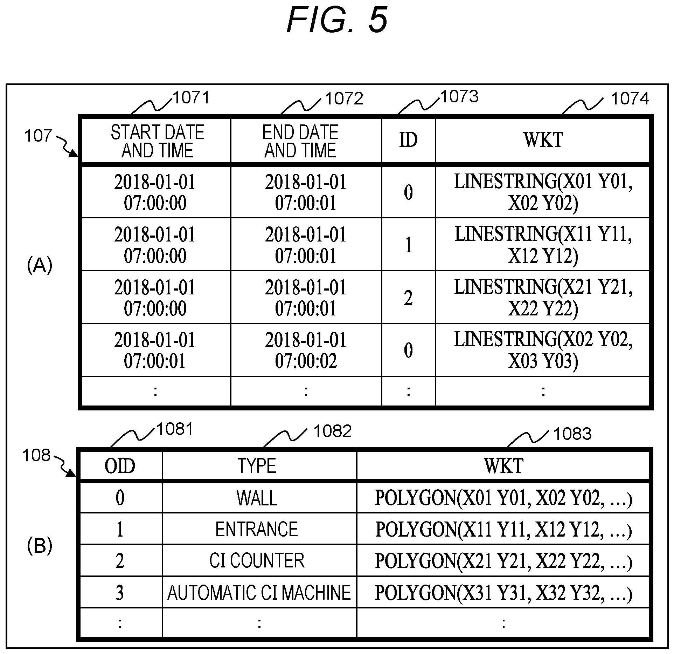

The measurement data acquisition unit 101 receives the series of flow line data 310 measured by the movement measurement system 11 via the communication network CN1. The measurement data acquisition unit 101 stores the series of flow line data 310 in the flow line database 107 (11M1). Layout information is input from the user 12 to the map data input unit 102. The map data input unit 102 stores the layout information in the layout database 108 (10M1). The flow line database 107 and the layout database 108 will be described later with reference to FIG. 5.

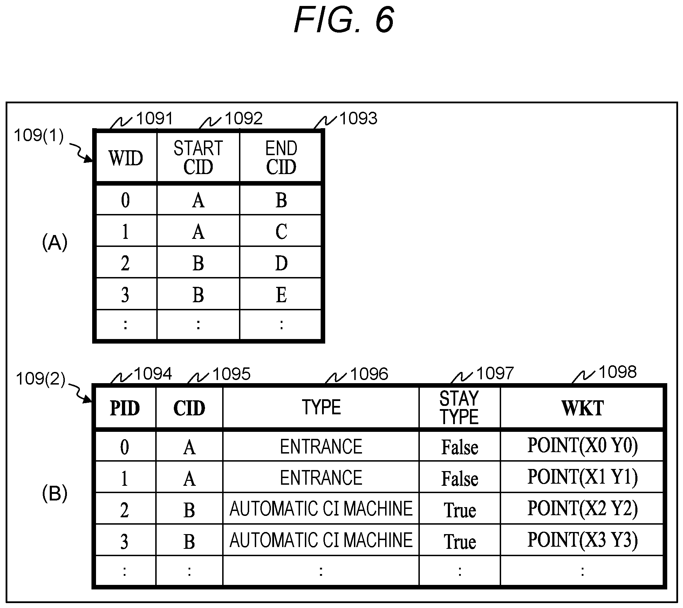

The user 12 inputs, to the workflow input unit 103, information on checkpoints 220 in the airport 20 and information on workflows. The input workflows may be referred to as definition workflows 1031. The workflow input unit 103 stores the information on the checkpoints 220 and the information on the definition workflows 1031 in the workflow database 109 (10M1). The workflow database 109 will be described later with reference to FIG. 6. Note that the processing 11M1 of the measurement data acquisition unit 101 and the processing 10M1 of the map data input unit 102 and the workflow input unit 103 may be parallel processing or sequential processing.

The workflow analysis unit 104 receives the layout information in the airport 20 from the layout database 108 (10M2), receives the information on the checkpoints 220 and the information on the definition workflows 1031 from the workflow database 109 (10M2), and receives the series of flow line data 310 from the flow line database 107 (10M3).

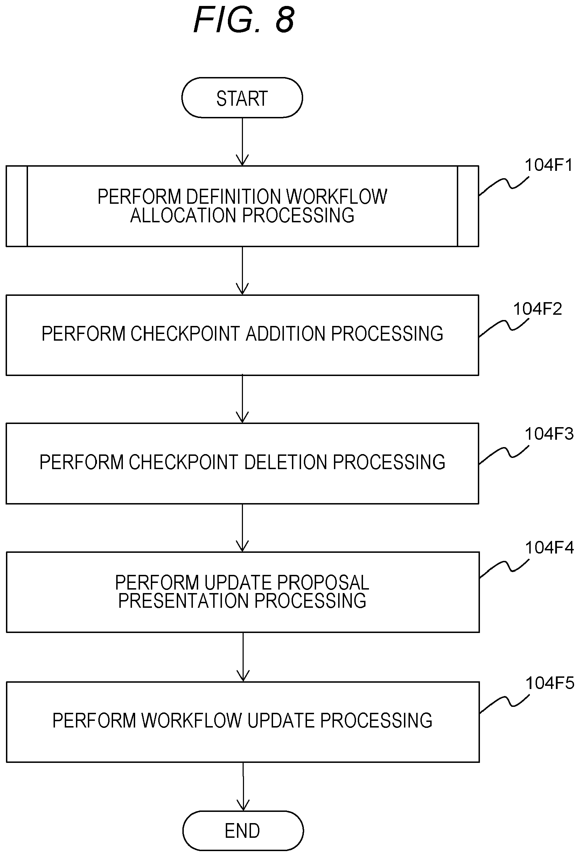

As will be described later with reference to FIG. 8, the workflow analysis unit 104 updates the information on the checkpoints 220 and the information on the definition workflows 1031 stored in the workflow database 109 by analyzing the series of flow line data 310 (10E1).

As illustrated in FIG. 1, the workflow analysis unit 104 includes a definition workflow allocation unit 1041, a difference extraction unit 1042, an update proposal presentation unit 1043, and a workflow update unit 1044.

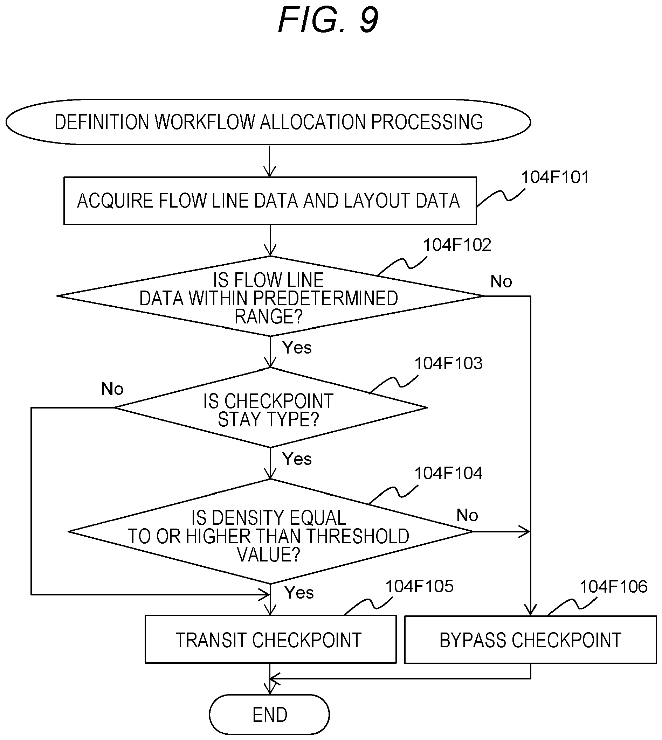

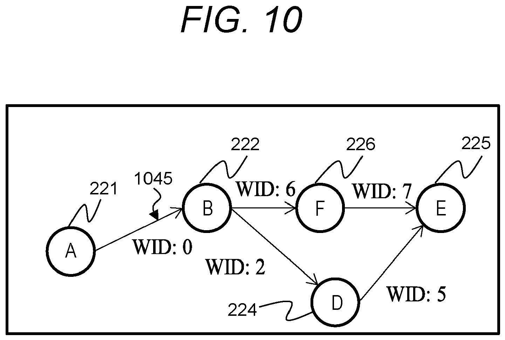

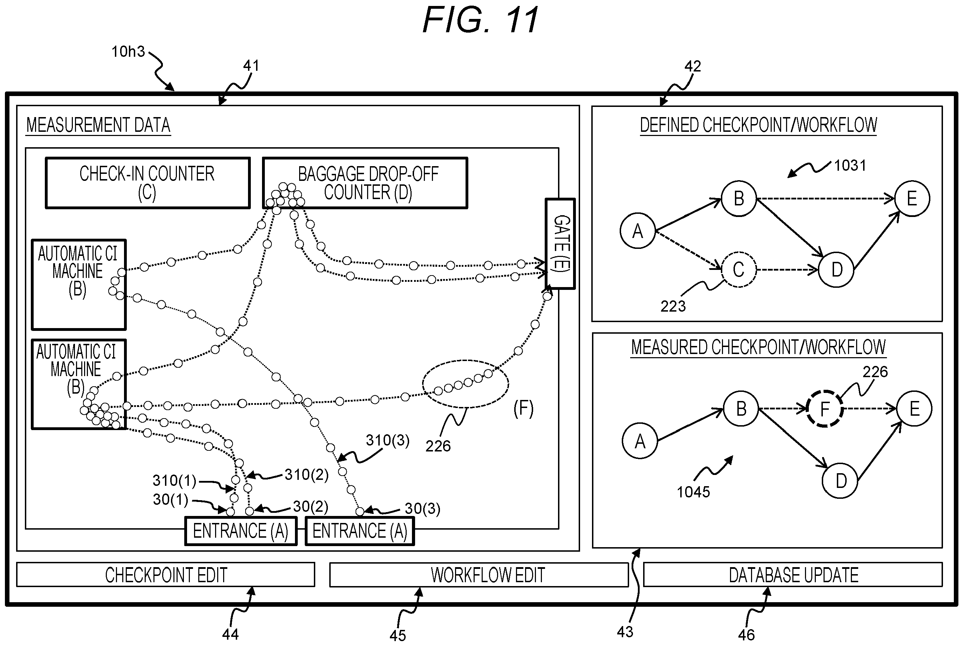

The definition workflow allocation unit 1041 collates the series of flow line data 310 with the checkpoints 220, as will be described later with reference to FIG. 9. The difference extraction unit 1042 extracts a difference between the definition workflows 1031 and the series of flow line data 310, as will be described later with reference to FIGS. 10 and 11. The update proposal presentation unit 1043 presents the difference between the definition workflows 1031 and the series of flow line data 310 on the monitor 10H3 (10M4).

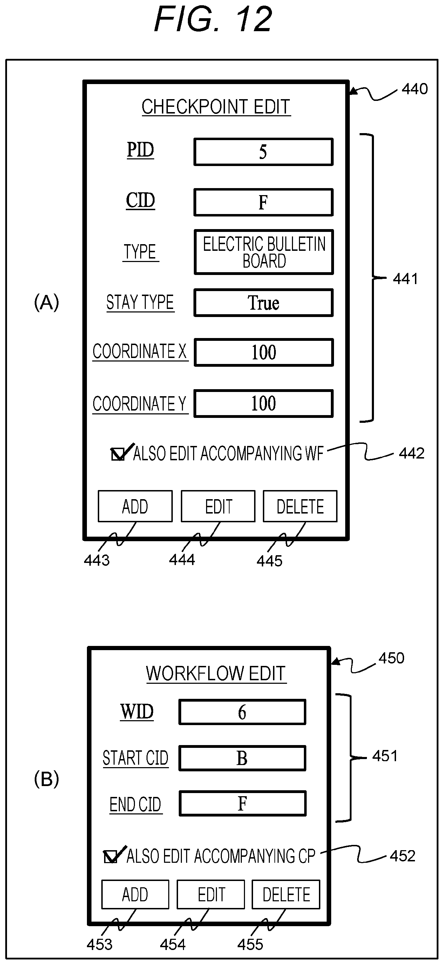

The user 12 inputs change contents of the workflows to the workflow update unit 1044 (10M5). The workflow update unit 1044 updates the workflow database 109 (10M6), as will be described later with reference to FIG. 12.

The flow line prediction model learning unit 105 receives the layout information in the airport 20 from the layout database 108 (10M7), receives the information on the checkpoints 220 and information on updated workflows from the workflow database 109 (10M7), and receives the series of flow line data 310 from the flow line database 107 (10M8).

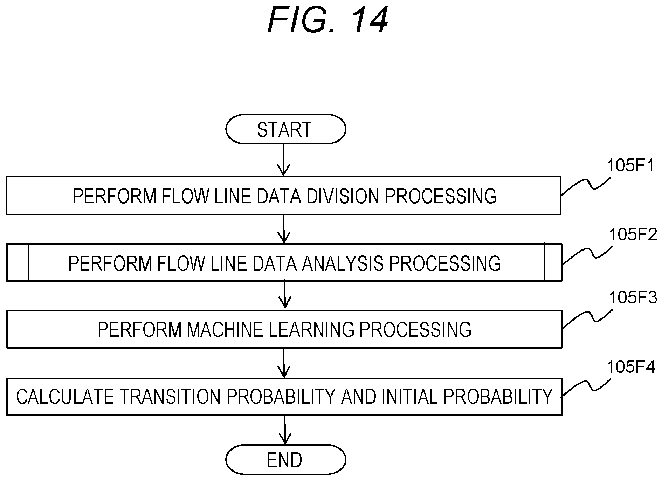

As will be described later with reference to FIG. 14, the flow line prediction model learning unit 105 performs machine learning on a flow line prediction model and generates parameters 1102 of the flow line prediction model (10E2).

As illustrated in FIG. 1, the flow line prediction model learning unit 105 includes a flow line data division unit 1051, a flow line data analysis unit 1052, and a machine learning unit 1053.

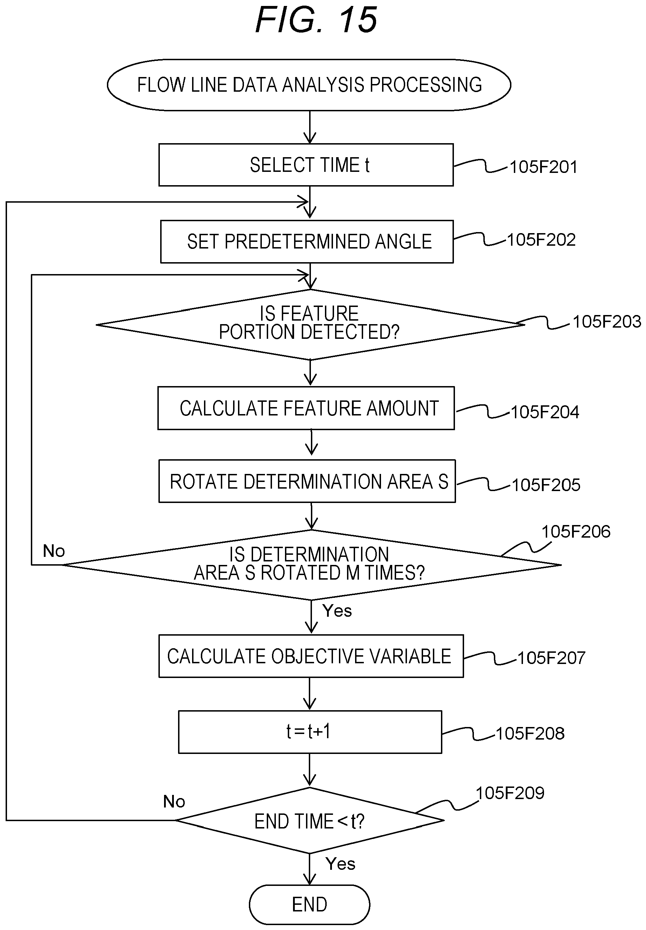

The flow line data division unit 1051 divides the series of flow line data 310 into a plurality of divisions. As will be described later with reference to FIG. 15, the flow line data analysis unit 1052 calculates a first feature amount located around a specific piece of position information 311b and a first objective variable.

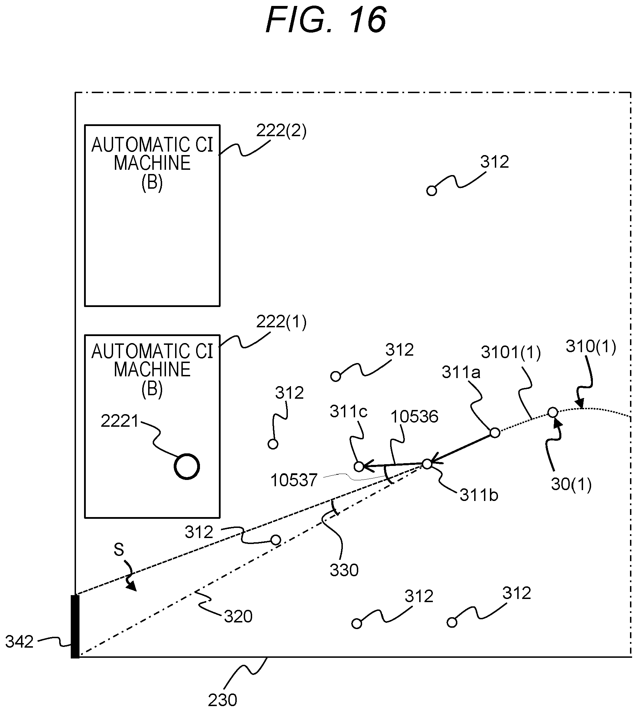

The first feature amount indicates, for example, distances from the specific piece of position information 311b to other persons 312, a wall 230, and a destination 2221 (see FIG. 16). A first objective variable 260 indicates, for example, a movement direction 10537 and a movement distance 10536. The movement distance 10536 indicates distances from the specific piece of position information 311b to a position of the person 30 after a predetermined time. The movement direction 10537 indicates an angle of a direction in which the person 30 located at the specific piece of position information 311b advances next.

The machine learning unit 1053 learns the flow line prediction model based on the first feature amount and the first objective variable. The flow line prediction model indicates an equation for calculating the first objective variable from the first feature amount. The flow line prediction model learning unit 105 stores the parameters 1102 of the learned flow line prediction model in the flow line prediction model database 110 (10M9).

The user 12 inputs new layout information, workflow information, or the like in the facility to the layout database 108 and the workflow database 109 (10M10).

The movement route prediction unit 106 receives the changed layout information in the airport 20 from the layout database 108 (10M11), receives the information on the checkpoints 220 and the updated workflows from the workflow database 109 (10M11), and receives the flow line prediction model from the flow line prediction model database 110 (10M12).

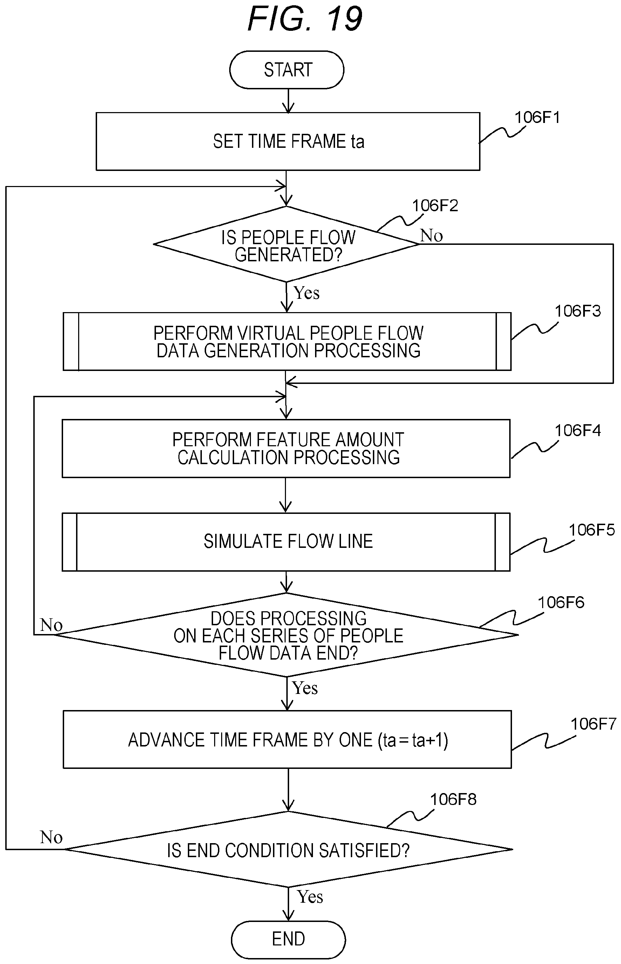

The movement route prediction unit 106 performs a flow line simulation based on the flow line prediction model, as will be described later with reference to FIG. 19 (10E3). As illustrated in FIG. 1, the movement route prediction unit 106 includes a virtual movement data generation unit 1061, a feature amount calculation unit 1062, and a simulation unit 1063.

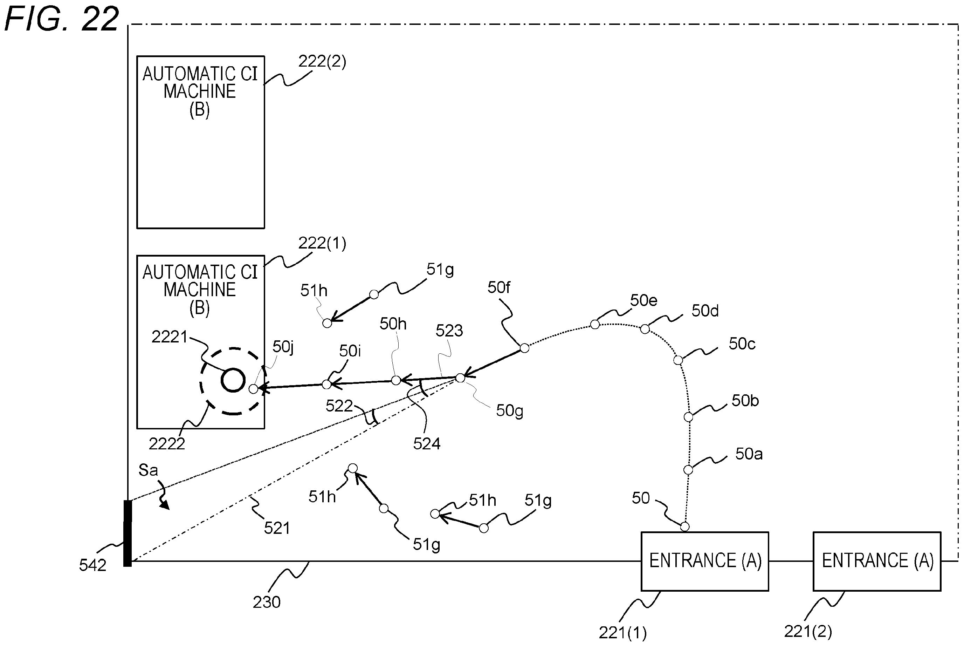

The virtual movement data generation unit 1061 generates a series of people flow data 50 as an example of a "virtual moving body" in a virtual space area provided in the memory 10H4 (see FIG. 22).

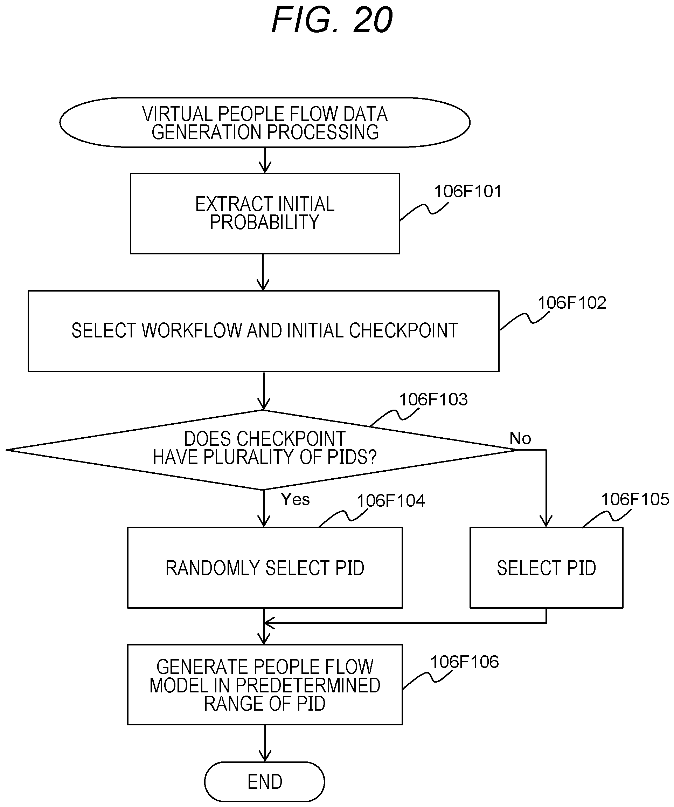

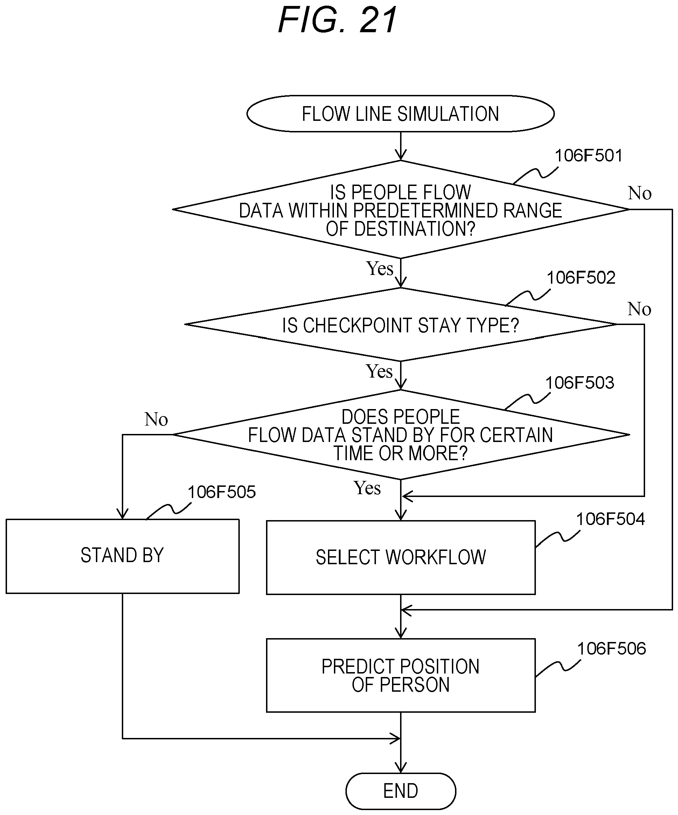

The feature amount calculation unit 1062 calculates a second feature amount of the series of people flow data 50, as will be described later with reference to FIG. 20. The second feature amount indicates, for example, distances from a specific piece of people flow data 50g to a piece of other people flow data 51g, the wall 230, and the destination 2221 (see FIG. 22). As will be described later with reference to FIG. 21, the simulation unit 1063 calculates a piece of people flow data 50h, where the piece of people flow data 50g advances next, to perform the movement.

The movement route prediction unit 106 stores a result of the flow line simulation in the flow line database 107 (10M13). When the processing in the movement route prediction unit 106 ends, the processing in the movement route prediction system 10 ends.

FIG. 4 is a measurement diagram of the moving bodies 30. The processing 11E1 of the movement measurement system 11 will be described.

The plurality of checkpoints 220 is arranged in the airport 20, for example. The checkpoints 220 includes entrances 221(1) and 221(2) as examples of a "departure checkpoint", automatic check-in (CI) machines 222(1) and 222(2), a check-in counter 223, and a baggage drop-off counter 224 as examples of an "intermediate checkpoint", and a gate 225 as an example of a "target checkpoint".

Note that the entrances 221(1) and 221(2) may be referred to as an entrance 221 unless otherwise specified. The automatic CI machines 222(1) and 222(2) may be referred to as an automatic CI machine 222 unless otherwise specified.

For example, the person 30(1) enters the airport 20 from the entrance 221(1), checks in with the automatic CI machine 222(1), and goes toward the gate 225. The person 30(2) enters the airport 20 from the entrance 221(1), checks in with the automatic CI machine 222(1), leaves baggage at the baggage drop-off counter 224, and goes toward the gate 225. The person 30(3) enters the airport 20 from the entrance 221(2), checks in with the automatic CI machine 222(2), leaves baggage at the baggage drop-off counter 224, and goes toward the gate 225.

For example, the movement measurement system 11 measures position information of the persons 30 moving in the airport 20 at predetermined intervals, and calculates the series of flow line data 310 of the persons 30. The series of flow line data 310(1) is information on a movement route of the person 30(1). The series of flow line data 310(2) is information on a movement route of the person 30(2). The series of flow line data 310(3) is information on a movement route of the person 30(3).

Series of position information 311(1), 311(2), and 311(3) indicate position information of the series of flow line data 310(1), 310(2), and 310(3) extracted at predetermined time intervals. Note that the series of position information 311(1), 311(2), and 311(3) may be referred to as a series of position information 311 unless otherwise specified. Note that the series of flow line data 310 may include a set of pieces of position information 311.

FIG. 5(A) is an example of the data structure of the flow line database 107. The flow line database 107 stores the series of flow line data 310 measured by the movement measurement system 11 or the result of the flow line simulation of the movement route prediction unit 106, which will be described later. The series of flow line data 310 is stored in the flow line database 107 in the form of a straight line connecting the pieces of position information 311.

Each of a start date and time 1071 and an end date and time 1072 stores, for example, measurement times when the pieces of position information 311 are measured. A piece of position information 311 at the start date and time 1071 is a start point of the straight line connecting the pieces of position information 311. A piece of position information 311 at the end date and time 1072 is an end point of the straight line connecting the pieces of position information 311. An identification (ID) 1073 stores identification numbers of the persons 30.

A well-known text (WKT) 1074 represents geometry information of the series of flow line data 310 from the start date and time 1071 to the end date and time 1072. Coordinates of the pieces of position information 311 measured at the start date and time 1071 and the end date and time 1072 are represented by X coordinates and Y coordinates of a plane rectangular coordinate system. The coordinate system for the geometry information stored in the WKT 1074 is not limited to the plane rectangular coordinate system, and any one may be adopted.

FIG. 5(B) is an example of the data structure of the layout database 108. The layout database 108 stores information on a shape of the wall 230 in the airport 20 and information on shapes of the checkpoints 220. An object identification (OID) 1081 represents identification information of the wall 230 and the checkpoints 220. A type 1082 represents a type of an obstacle such as the wall 230 and types of the checkpoints 220.

A WKT 1083 represents data of outer shapes of the wall 230 and the checkpoints 220 as geometry information. The coordinate system for the geometry information stored in the WKT 1083 is not limited to the plane rectangular coordinate system, and any one may be selected.

FIG. 6(A) is correspondence information 109(1) between the definition workflows 1031 and the checkpoints 220. A workflow identification (WID) 1091, a start checkpoint identification (CID) 1092, and an end CID 1093 are stored in the definition workflows 1031 and the checkpoint correspondence information 109(1).

The WID 1091 stores identification information of the definition workflows 1031. The start CID 1092 and the end CID 1093 store checkpoints 220 at start points where the person 30 starts moving and checkpoints 220 at destinations. Note that identification information of the checkpoints 220 is similar to a CID 1095 described later with reference to FIG. 6(B).

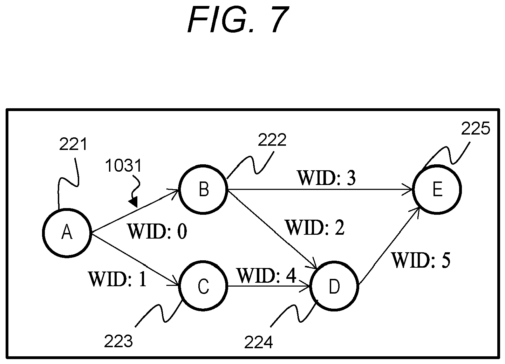

FIG. 7 is a diagram illustrating the definition workflows 1031 in a directed graph. Nodes 221 to 225 indicate the checkpoints 220. Directed vectors connecting the nodes 221 to 225 indicate the movement of the person 30, and the WID 1091 is allocated to each directed vector.

Specifically, the definition workflows 1031 are set so that, for example, a person enters the entrance 221 in the airport 20 and goes toward the automatic CI machine 222 or the check-in counter 223 (WID = 0, WID = 1). The definition workflows 1031 are set so that the person 30 goes from the automatic CI machine 222 toward the baggage drop-off counter 224 or the gate 225 (WID = 2, WID = 3). The definition workflows 1031 are set so that the person 30 goes from the check-in counter 223 toward the gate 225 via the baggage drop-off counter 224 (WID = 4, WID = 5).

FIG. 6(B) is a diagram illustrating detailed checkpoint information 109(2). The detailed checkpoint information 109(2) stores data of a point identification (PID) 1094, the CID 1095, a type 1096, a stay type determination 1097, and a WKT 1098.

The PID 1094 indicates identification information of the checkpoints 220. The CID 1095 indicates identification information related to types of the checkpoints 220. In the CID 1095, for example, the entrance 221 is indicated as A, the automatic CI machine 222 is indicated as B, the check-in counter 223 is indicated as C, the baggage drop-off counter 224 is indicated as D, and the gate 225 is indicated as E. Note that a plurality of PIDs 1094 may be allocated to one type of checkpoints 220. Since the plurality of entrances 221 is arranged in the airport 20, for example, PID = 0 and PID = 1 are allocated for CID = A. The type 1096 represents the types of the checkpoints 220.

The stay type determination 1097 indicates attributes of the checkpoints 220. Each of the attributes is either a stay type or a passing type. The stay type determination 1097 indicates True if a checkpoint 220 is the stay type. The stay type determination 1097 indicates False if a checkpoint 220 is the passing type.

The WKT 1098 represents geometry information related to coordinate information of the checkpoints 220. The coordinate system for the WKT 1098 is not limited to the plane rectangular coordinate system, and any coordinate system may be adopted.

FIG. 8 is a flowchart of the workflow analysis unit 104. The processing 10E1 of the workflow analysis unit 104 will be described. The processing 10E1 of the workflow analysis unit 104 moves to processing 104F1 of the definition workflow allocation unit 1041.

FIG. 9 is a flowchart of the definition workflow allocation unit 1041. The processing 104F1 of the definition workflow allocation unit 1041 determines, for example, whether the person 30 has transited a checkpoint 220. As an example of the processing 104F1, for example, it is determined whether the series of flow line data 310(1) has transited the automatic CI machine 222(1) (see FIG. 4).

Note that the term "transit" in the present embodiment means that the person 30 performs a specific action at each of the checkpoints 220.

The definition workflow allocation unit 1041 acquires information on the series of flow line data 310(1) and information on the automatic CI machine 222(1) (104F101). The definition workflow allocation unit 1041 determines that the series of flow line data 310(1) has passed within a predetermined range 2222 of the automatic CI machine 222(1) based on the WKT 1074 of the flow line database 107 and the WKT 1098 of the workflow database 109 (104F102: Yes). The definition workflow allocation unit 1041 determines from the detailed checkpoint information 109(2) that the automatic CI machine 2221(1) is the stay type (104F103: Yes).

The definition workflow allocation unit 1041 determines that the density of the series of position information 311(1) of the series of flow line data 310(1) is equal to or higher than a threshold value (104F101: Yes). Note that a method of calculating the density of the series of position information 311(1) includes, for example, measuring the number of pieces in the series of position information 311(1) located within the predetermined range 2222.

As a result, the definition workflow allocation unit 1041 determines that the series of flow line data 310(1) has transited the automatic CI machine 222(1) (104F105). After determining whether each series of flow line data 310 has transited each of the checkpoints 220, the processing 104F1 of the definition workflow allocation unit 1041 ends.

Note that, if a checkpoint 220 is the passing type (104F103: No), the definition workflow allocation unit 1041 determines that the person 30 has passed through the passing type checkpoint 220 (104F105).

Note that, if the series of flow line data 310 does not pass within the predetermined range of the checkpoint 220 (104F102: No) and if the density of the series of position information 311 is lower than the threshold value (104F104: No), it is determined that the series of flow line data 310 does not transit the checkpoint 220 (104F106).

FIG. 10 is a diagram illustrating flow line workflows 1045 in a directed graph. The flow line workflows 1045 are, for example, transit information of the person 30 moving in the airport 20 determined by the definition workflow allocation unit 1041. Specifically, the person 30 enters the entrance 221 in the airport 20 and goes toward the automatic CI machine 222 (WID = 0). The person 30 having arrived at the automatic CI machine 222 goes toward the baggage drop-off counter 224 or a high-density range 226 (WID = 2, WID = 6). The person 30 having arrived at the baggage drop-off counter 224 or the person 30 having arrived at the high-density range 226 goes toward the gate 225 (WID = 5, WID = 7) .

The processing of the workflow analysis unit 104 moves to addition processing 104F2 of the difference extraction unit 1042 (see FIG. 8). The addition processing 104F2 of the difference extraction unit 1042 sets a point with a high density of the series of position information 311 as an addition candidate.

The difference extraction unit 1042 acquires the high-density range 226 in which the density of the series of position information 311 is equal to or higher than a certain threshold value (see FIG. 4). The high-density range 226 is formed, for example, on the series of flow line data 310(1) between the automatic CI machine 222(1) and the gate 225. If the high-density range 226 is separated from each of the checkpoints 220 by a certain distance or more, the difference extraction unit 1042 counts the high-density range 226 as an addition candidate.

The difference extraction unit 1042 acquires an addition candidate of each series of flow line data 310 other than the series of flow line data 310(1). Since it is determined that the high-density range 226 is not formed on each series of flow line data 310 other than the series of flow line data 310(1), the count of addition candidates of the high-density range 226 is "1". If a threshold value of the count is "1", the difference extraction unit 1042 transmits information on the high-density range 226 as an addition candidate to the update proposal presentation unit 1043. That is, if the count of addition candidates is equal to or higher than the threshold value, the high-density range 226 is transmitted to the update proposal presentation unit 1043 as an addition candidate.

The processing of the workflow analysis unit 104 moves to checkpoint deletion processing 104F3 of the difference extraction unit 1042. The checkpoint deletion processing 104F3 transmits, to the update proposal presentation unit 1043, a checkpoint 220 which the person 30 does not transit as a deletion candidate.

The difference extraction unit 1042 determines, for example, whether the series of flow line data 310(1) has transited the check-in counter 223, which is the stay type. Since the series of flow line data 310(1) does not pass near the check-in counter 223, the difference extraction unit 1042 determines that the density of the series of position information 311(1) of the series of flow line data 310(1) in the predetermined range of the check-in counter 223 is lower than the certain threshold value.

As a result, the difference extraction unit 1042 counts the check-in counter 223 as a deletion candidate. The difference extraction unit 1042 determines, for example, whether other series of flow line data 310 other than the series of flow line data 310(1) have also transited the check-in counter 223. If the series of flow line data 310(1), 310(2), and 310(3) do not transit the check-in counter 223 and a threshold value of the counter is "3", the checkpoint deletion processing 104F3 transmits the check-in counter 223 as a deletion candidate to the update proposal presentation unit 1043. That is, if the count of deletion candidates is equal to or higher than the threshold value, the difference extraction unit 1042 transmits, to the update proposal presentation unit, the checkpoint 220 where the density of the series of flow line data 310 in the predetermined range is lower than the certain threshold value, as a deletion candidate.

Note that, if a checkpoint 220 is the passing type, the difference extraction unit 1042 acquires the series of flow line data 310 within the predetermined range of the checkpoint 220. If the series of flow line data 310 does not pass within the predetermined range of the checkpoint 220, the difference extraction unit 1042 counts the passing type checkpoint 220 as a deletion candidate.

The processing of the workflow analysis unit 104 moves to processing (104F4) of the update proposal presentation unit 1043 (see FIG. 8). For example, the update proposal presentation unit 1043 displays, on the monitor 10H3, the addition candidate and the deletion candidate of the checkpoints 220 generated by the difference extraction unit 1042 to present, to the user 12, the addition candidate and the deletion candidate of the checkpoints 220.

FIG. 11 is an explanatory diagram of the update proposal presentation unit 1043. The update proposal presentation unit 1043 displays, on the monitor 10H3, for example, a screen 41 that measures the persons 30 moving in the airport 20, a screen 42 that shows the definition workflows 1031, a screen 43 that shows the flow line workflows 1045, a checkpoint edit button 44, a workflow edit button 45, and a database update button 46.

The screen 41 displays routes of the persons 30 moving in the airport 20. The screen 42 displays the definition workflows 1031. On the screen 42, for example, the check-in counter 223, which is a deletion candidate, is represented by a dotted line. The screen 43 displays the flow line workflows 1045. On the screen 43, for example, the high-density range 226, which is an addition candidate, is displayed with a dotted line.

The checkpoint edit button 44 is a button for moving to an edit screen of a checkpoint 220. Note that the user 12 selects, for example, the high-density range 226 of the screen 43, and then selects the checkpoint edit button 44.

Note that various buttons, checkpoints, and the like displayed on the monitor 10H3 may be selected by a screen like a touch panel being simply touched, or the buttons may be selected by input with a mouse cursor or a keyboard.

FIG. 12(A) is an explanatory diagram of a checkpoint edit box 440. The checkpoint edit box 440 is displayed on the monitor 10H3 when the user 12 selects the checkpoint edit button 44.

On the checkpoint edit box 440, an information editing unit 441 of the checkpoint 220, a check box 442, an add button 443, an edit button 444, and a delete button 445 are displayed.

The user 12 inputs, for example, the information on the high-density range 226 in text boxes of the information editing unit 441 of the checkpoint 220. The user 12 inputs the information with the high-density range 226 set as an electric bulletin board 226, for example. The user 12 can set a flag indicating that the information on the high-density range 226 is added to the workflow database 109, by pressing the add button 443. Note that, if the user 12 presses the edit button 444 and the delete button 445, a flag indicating that the checkpoint 220 is edited and a flag indicating that the checkpoint 220 is deleted can be set.

The user 12 can proceed to edit a workflow after pressing the add button 443 by checking the check box 442. Note that the same applies even after the user 12 presses the edit button 444 and the delete button 445.

Returning to FIG. 11, the workflow edit button 45 is a button for transitioning to an edit screen of a workflow. FIG. 12(B) is an explanatory diagram of a workflow edit box 450. The workflow edit box 450 is displayed on the monitor 10H3 when the user 12 selects the workflow edit button 45. The workflow edit box 450 includes an information editing unit 451 of the workflow and checkpoints 220, a check box 452, an add button 453, an edit button 454, and a delete button 455.

The user 12 inputs information on the workflow (WID = 6) in text boxes of the information editing unit 451 of the workflow and the checkpoints 220, for example. The user 12 can set a flag indicating that the information on the workflow (WID = 6) is added to the workflow database 109, by selecting the add button 453. Note that, if the user 12 presses the edit button 454 and the delete button 455, a flag indicating that the checkpoint 220 is edited and a flag indicating that the checkpoint 220 is deleted can be set.

The user 12 can proceed to edit the checkpoints after pressing the add button 453 by checking the check box 452. Note that the same applies even after the user 12 presses the edit button 454 and the delete button 455.

Returning to FIG. 11, when the user 12 presses the database update button 46, the processing of the workflow analysis unit 104 moves to workflow update processing (104F5) of the workflow update unit 1044 (see FIG. 8). The workflow update unit 1044 updates the workflow database 109 based on the information input by the user 12 in the checkpoint edit box 440 and the workflow edit box 450.

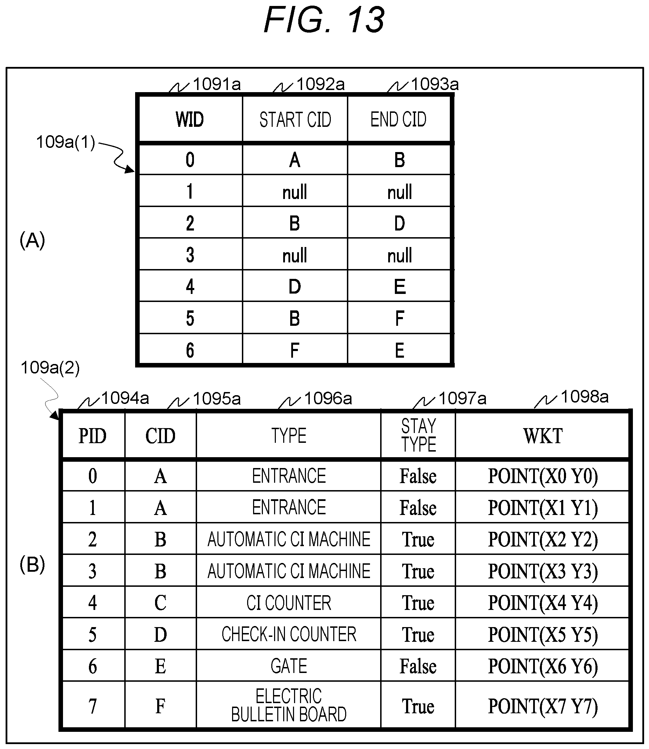

FIG. 13(A) is a diagram illustrating correspondence information 109a(1) between the updated workflows and checkpoints 220. The correspondence information 109a(1) between the updated workflows and checkpoints 220 stores a WID 1091a, a start CID 1092a, and an end CID 1093a. The workflow update unit 1044 deletes the workflows (WID = 1, WID = 3) from the workflow database 109, for example. The workflow update unit 1044 adds the workflows (WID = 5, WID = 6), for example.

FIG. 13(B) is a diagram illustrating detailed information 109a(2) of the updated checkpoints 220. The detailed information 109a(2) of the updated checkpoints 220 stores a PID 1094a, a CID 1095a, a type 1096a, a stay type determination 1097a, and a WKT 1098a. The workflow update unit 1044 adds the information on the electric bulletin board 226.

FIG. 14 is a flowchart of the flow line prediction model learning unit 105. The processing 10E2 of the flow line prediction model learning unit 105 will be described. The processing 10E2 of the flow line prediction model learning unit 105 moves to flow line data division processing (105F1) of the flow line data division unit 1051.

The flow line data division unit 1051 acquires the start CID 1092a and the end CID 1093a of a predetermined workflow. The flow line data division unit 1051 determines whether the series of flow line data 310 has transited the acquired start CID 1092a and end CID 1093a. A determination method is similar to the processing 104F1 of the definition workflow allocation unit 1041.

The flow line data division unit 1051 acquires pieces of position information of the start CID 1092a and the end CID 1093a. The flow line data division unit 1051 acquires, from the series of flow line data 310, a piece of divided flow line data corresponding to the predetermined workflow based on the pieces of position information of the start CID 1092a and the end CID 1093a.

The divided flow line data include, for example, a first piece of divided flow line data 3101 to a fifth piece of divided flow line data 3105 (see FIG. 4). The first piece of divided flow line data 3101 corresponds to the workflow (WID = 0). The second piece of divided flow line data 3102 corresponds to the workflow (WID = 2). The third piece of divided flow line data 3103 corresponds to the workflow (WID = 5). The fourth piece of divided flow line data 3104 corresponds to the workflow (WID = 6). The fifth piece of divided flow line data 3105 corresponds to the workflow (WID = 7) .

Specifically, the flow line data division unit 1051 selects the workflow (WID = 0) from the entrance 221 to the automatic CI machine 222, for example. The flow line data division unit 1051 acquires pieces of position information (WKT 1098a) of the entrance 221(1) and the automatic CI machine 222(1). The flow line data division unit 1051 associates the series of flow line data 310(1) with the pieces of position information (WKT 1098a) of the entrance 221(1) and the automatic CI machine 222(1), to acquire a first piece of divided flow line data 3101(1).

The flow line data division unit 1051 acquires, in the series of flow line data 310(1), a fourth piece of divided flow line data 3104(1) and a fifth piece of divided flow line data 3105(1) for the workflows (WID = 6, 7), as with the workflow (WID = 0). As a result, the flow line data division unit 1051 divides the series of flow line data 310(1) into a plurality of divisions.

The flow line data division unit 1051 acquires pieces of divided flow line data of the series of flow line data 310(2) and 310(3) by similar processing to the processing on the series of flow line data 310(1). Note that the pieces of divided flow line data of the series of flow line data 310(2) and 310(3) are shown by, for example, first pieces of divided flow line data 3101(2) and 3101(3), second pieces of divided flow line data 3102(2) and 3102(3), and third pieces of divided flow line data 3103(2) and 3103(3).

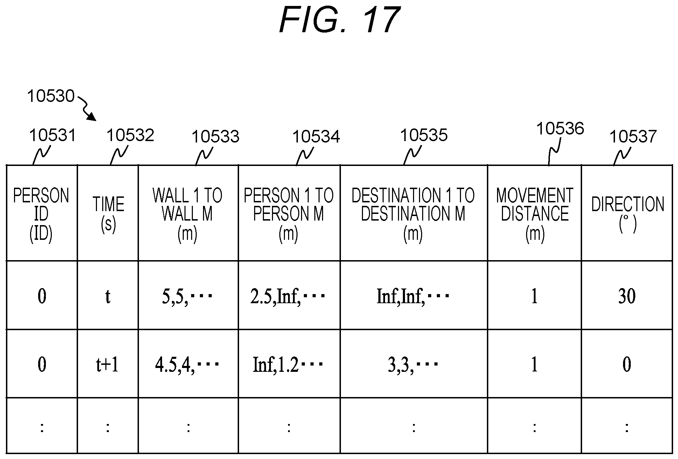

The processing of the flow line prediction model learning unit 105 moves to people flow feature amount calculation processing (105F2) of the flow line data analysis unit 1052. FIG. 15 is a flowchart of the flow line data analysis unit 1052. The processing (105F2) of the flow line data analysis unit 1052 will be described with reference to FIGS. 16 and 17.

FIG. 16 illustrates an example of the series of flow line data 310(1) of the person 30(1) going toward the automatic CI machine 222(1). Pieces of position information 311a, 311b, and 311c of the series of flow line data 310(1) indicate pieces of position information of the person at times t - 1, t, and t + 1, respectively (105F201). The time t - 1 indicates a predetermined time before the time t. The time t + 1 indicates a predetermined time after the time t.

Pieces of other position information 312 are position information of other persons other than the person 30(1) at the time t. The destination 2221 is the piece of position information of the automatic CI machine 222(1).

FIG. 17 is an explanatory diagram of the first feature amount and the first objective variable. A table 10530 of the flow line data analysis unit 1052 includes a person ID 10531, which is identification information of the persons 30, a time 10532, information 10533 on distances to walls, information 10534 on distances to other persons, information 10535 on distances to destinations, the movement distance 10536, and the movement angle 10537.

Returning to FIG. 15, the flow line data analysis unit 1052 sets a predetermined angle 330 in front of the piece of position information 311b (105F202), and sets a first determination area S. For example, the flow line data analysis unit 1052 sets the first determination area S in an area having the first predetermined angle 330 from a first reference direction 320 as an example of a "first predetermined direction". The first reference direction 320 is set in the same direction as a straight line direction from the piece of position information 311a to the piece of position information 311b.

The flow line data analysis unit 1052 detects a first feature portion located in the first determination area S (105F203). The first feature portion includes, for example, obstacles for the person 30, such as the other persons 312 and the wall 230, and the destination 2221 for the person 30.

Since a piece of other position information 312 of another person is located in the first determination area S (105F203: Yes), the flow line data analysis unit 1052 calculates a distance from the piece of position information 311b to the piece of other position information 312 located in the first determination area S (105F204). The distance to the piece of other position information 312 is stored in the information 10534 on distances to other persons.

Note that, if there is a plurality of pieces of other position information 312 in the first determination area S, the flow line data analysis unit 1052 may calculate, as a feature amount, a statistic of distances to the plurality of pieces of other position information 312. If no piece of other position information 312 is located in the first determination area S, the flow line data analysis unit 1052 may store infinity (Inf) or a specific fixed value as a feature amount value in the information 10534 on distances to other persons.

Since a part 342 of a wall is located in the first determination area S (105F203: Yes), the flow line data analysis unit 1052 calculates a distance from the piece of position information 311b to the part 342 of the wall (105F204). The distance from the piece of position information 311b to the part 342 of the wall is stored in the information 10533 on distances to walls.

Note that the part 342 of the wall located in the first determination area S may be detected when the part 342 of the wall is arranged so as to intersect the first reference direction 320. Note that, regarding the distance from the piece of position information 311b to the part 342 of the wall, a distance between the center of gravity of the part 342 of the wall and the piece of position information 311b may be used as a feature amount, or the shortest distance between the part 342 of the wall and the piece of position information 311b may be used as a feature amount. When interference between the part 342 of the wall and the first determination area S, the flow line data analysis unit 1052 may store the Inf or a specific value in the information 10533 on distances to walls if an intersection area does not exist and the wall 230 does not exist.

Since the destination 2221 is located outside a first determination area S(1) (105F203: No), the flow line data analysis unit 1052 stores, for example, the Inf or a specific value as a feature amount value in the information 10535 on distances to destinations. Note that if a plurality of destinations 2221 is located in the first determination area S, a statistic of distances between the destinations 2221 and the piece of position information 311b is calculated as a feature amount.

Note that the flow line data analysis unit 1052 may add, as a feature amount, information such as speed, acceleration, or movement vectors when the person 30(1) moves from the piece of position information 311a to the piece of position information 311b, for example. At this time, information of the speed, acceleration, or movement vectors may be calculated in a polar coordinate system based on a direction from the piece of position information 311a to the piece of position information 311b.

The flow line data analysis unit 1052 rotates the first determination area S by each first predetermined angle 330 (105F205). The flow line data analysis unit 1052 detects the first feature portion in the first determination area S after rotation. The first determination area S is rotated M times (105F206). The predetermined number of times M is set to the number obtained by dividing 2π by the first predetermined angle 330. That is, M pieces of data of the information 10533 on distances to walls, the information 10534 on distances to other persons, and the information 10535 on distances to destinations are calculated.

The flow line data analysis unit 1052 stores the first objective variable in the piece of position information 311b (105F207). The first objective variable is, for example, the movement distance 10536 and the movement direction 10537. The movement distance 10536 is, for example, a distance between the piece of position information 311b and the piece of position information 311c. The movement direction 10537 is, for example, an angle between the first reference direction 320 and a straight line connecting the piece of position information 311b and the piece of position information 311c.

Note that the first objective variable may be information such as the speed or acceleration when the person 30(1) moves from the piece of position information 311b to the piece of position information 311c. Note that, as the first objective variable, information such as the speed or acceleration may be calculated in the polar coordinate system based on the movement direction 10537.

The flow line data analysis unit 1052 advances the time t by a predetermined time, so that the person 30(1) moves from the piece of position information 311b to the piece of position information 311c (105F208). The flow line data analysis unit 1052 similarly calculates a first feature amount and a first objective variable at the position 311c. If a first feature amount and a first objective variable of the person 30(1) located at the destination 2221 are calculated (105F209: Yes), the processing of the flow line data analysis unit 1052 ends.

Returning to FIG. 14, the processing of the flow line prediction model learning unit 105 moves to processing (105F3) of the machine learning unit 1053. In the processing (105F3) of the machine learning unit 1053, machine learning is performed on the first feature amount and the first objective variable for each workflow obtained by the processing (105F2) of the flow line data analysis unit 1052, so that the flow line prediction model is learned. A machine learning method used here is to learn a function that predicts the first objective variable from the first feature amount, and may be, for example, a gradient boosting regression tree, a suppport vector regression, a long short term memory, or the like. Note that parameters 1102(1) to 1102(N) of the flow line prediction model of people flow data for each learned workflow are stored in the flow line prediction model database 110. Note that the parameters 1102(1) to 1102(N) of the flow line prediction model may be referred to as parameters 1102 unless otherwise specified.

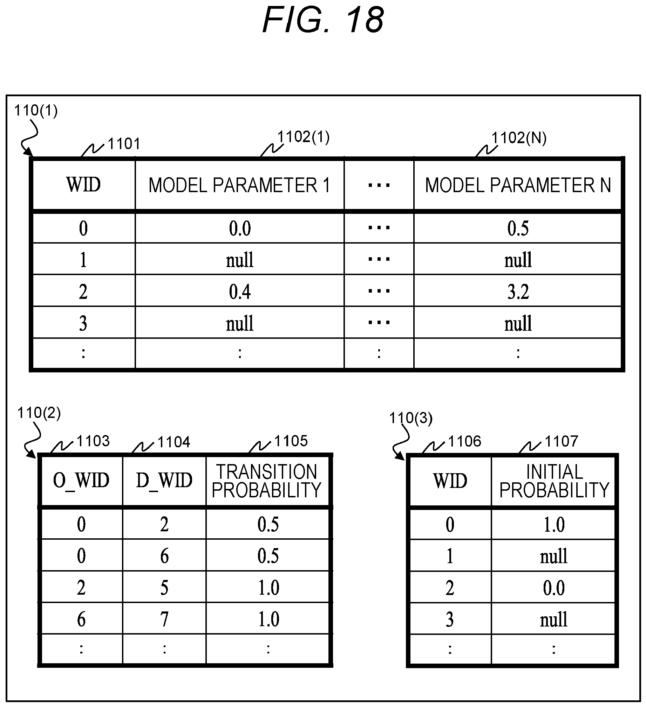

When the machine learning in each workflow ends, the flow line prediction model learning unit 105 calculates a transition probability 1105 and an initial probability 1107 (see FIG. 18) of the workflows of the person 30 (105F4) . The transition probability 1105 indicates a probability that the person 30 transitions from a workflow to another workflow. The initial probability 1107 indicates, for example, a checkpoint 220 at which the person 30 is first located.

Note that the transition probability 1105 and the initial probability 1107 may be calculated from statistics of the series of flow line data 310 of the plurality of persons 30. The transition probability 1105 and the initial probability 1107 are stored in the flow line prediction model database 110.

After the processing of the machine learning unit 1053 ends, processing (11E2) of the flow line prediction model learning unit 105 ends.

FIG. 18 is a diagram illustrating the data structure of the flow line prediction model database 110. The flow line prediction model database 110 includes an operation prediction parameter 110(1), a transition probability 110(2) between the checkpoints, and an initial probability 110(3) of the checkpoints.

The operation prediction parameter 110(1) stores a WID 1101 and the parameters 1102 of the flow line prediction model. The WID 1101 represents workflow IDs and corresponds to the WID 1091a (see FIG. 13). The parameters 1102 of the flow line prediction model are represented as, for example, N-dimensional vectors.

The transition probability 110(2) between the checkpoints stores an O_WID 1103, a D_WID 1104, and the transition probability 1105. The O_WID 1103 and the D_WID 1104 correspond to WIDs before and after transition of workflows, and the transition probability 1105 represents a probability of the transition from the O_WID 1103 to the D_WID 1104.

The persons 30 go toward the automatic CI machine 222 from the entrance 221 (WID = 0), and then go toward either the baggage drop-off counter 224 or the electric bulletin board 226. If the number of persons 30 going from the automatic CI machine 222 toward the baggage drop-off counter 224 and the number of persons 30 going from the automatic CI machine 222 toward the electric bulletin board 226 are the same, a calculation result of the transition probability 1105 in the flow line prediction model learning unit 105 is, for example, "0.5" for both. Note that, if there is no branch point, the transition probability 1105 is "1.0".

The initial probability 110(3) of the checkpoints stores a WID 1106 and the initial probability 1107. The WID 1106 corresponds to the WID 1101. In the flow line workflows 1045, a checkpoint toward which the person goes next to the entrance 221 is the automatic CI machine 222, and thus the initial probability of the workflow (WID = 0) is "1.0".

FIG. 19 is a flowchart of the movement route prediction unit 106. The processing 10E3 of the movement route prediction unit 106 will be described by taking the series of people flow data 50 illustrated in FIG. 22 as an example (see FIG. 3).

FIG. 22 is an explanatory diagram of the movement route prediction unit 106. The series of people flow data 50 is a virtual moving body generated at the entrance 221(1) and moving toward the destination 2221 in the automatic CI machine 222(1). The series of people flow data 50 moves as indicated by pieces of people flow data 50a to 50j. The pieces of people flow data 50a to 50j are obtained by sampling of the series of people flow data 50 for each time frame ta.

The movement route prediction unit 106 sets the time frame ta (106F1). The time frame ta is, for example, a time set in the flow line simulation performed by the movement route prediction unit 106. The time frame ta is set, for example, at certain intervals, a time frame ta one interval after (predetermined time after) the predetermined time frame ta is referred to as a time frame ta + 1, and a time frame ta one interval before (predetermined time before) the time frame ta is referred to as a time frame ta - 1.

If the series of people flow data 50 is generated in the set time frame ta (106F2: Yes), the movement route prediction unit 106 moves to processing (106F3) of the virtual movement data generation unit 1061. If it is determined that the series of people flow data 50 is not generated (106F3: No), the processing of the movement route prediction unit 106 moves to people flow feature amount generation processing (106F4).

FIG. 20 is a flowchart of the virtual movement data generation unit 1061. The virtual movement data generation unit 1061 extracts the initial probability 1107 (see FIG. 18) of each workflow (106F101). For example, since the initial probability 1107 of the workflow (WID = 0) is "1.0", the virtual movement data generation unit 1061 sets a checkpoint 220 at which the series of people flow data 50 is generated to the entrance 221 (106F102).

Since the entrance 221 has a plurality of PIDs (see FIG. 6), either PID = 0 or PID = 1 is randomly selected (106F103: Yes, 106F104). If a predetermined PID corresponding to a predetermined CID 1095 is singular (106F103: No), the virtual movement data generation unit 1061 selects the predetermined PID (106F105).

Note that, in the processing (106F104), the virtual movement data generation unit 1061 may aggregate PIDs 1094 of checkpoints 220 from which the series of flow line data 310 stored in the database 107 is started and determine a movement start position from a frequency distribution of the PIDs 1094, instead of randomly selecting the PID.

The virtual movement data generation unit 1061 generates, for example, the series of people flow data 50 at the entrance 221(1) (106F106). Note that a movement start time of the series of people flow data 50 may be randomly determined. The virtual movement data generation unit 1061 may aggregate, regarding the series of flow line data 310 stored in the flow line database 107, start times of the series of flow line data 310 corresponding to the workflow and determine the movement start time from a frequency distribution of the start times.

The processing of the movement route prediction unit 106 moves to the processing (106F4) of the feature amount calculation unit 1062 (see FIG. 19). Note that the processing (106F4) is similar to the processing (105F201 to 105F606) of the flow line data analysis unit 1052 illustrated in FIG. 15. That is, the processing of the movement route prediction unit 106 detects a second feature portion by rotating a second determination area, which will be described later, around a specific piece of people flow data 50. The second feature portion includes, for example, obstacles for the series of people flow data 50, such as pieces of other people flow data 51 and the wall 230, and the destination 2221 of the series of people flow data 50. Pieces of other people flow data 51g and 51h are people flow data other than the series of people flow data 50. Note that the pieces of other people flow data 51g and 51h may be referred to as a piece of other people flow data 51 unless otherwise specified.

The processing (106F4) will be described by focusing on the piece of people flow data 50g in the predetermined time frame ta. The feature amount calculation unit 1062 sets a second determination area Sa in an area having a second predetermined angle 522 from a second reference direction 521 as an example of a "second predetermined direction". The second reference direction 521 is a straight line direction from a piece of people flow data 50f to the piece of people flow data 50g.

A part 542 of a wall is located in the second determination range Sa. The feature amount calculation unit 1062 calculates a distance from the piece of people flow data 50g to the part 542 of the wall. If a piece of other people flow data 51 and the destination 2221 are located within the second determination range Sa, the feature amount calculation unit 1062 calculates distances from the piece of people flow data 50g to the piece of other people flow data 51 and the destination 2221.

The feature amount calculation unit 1062 rotates the first determination area Sa by each second predetermined angle 522 around the piece of people flow data 50g. The flow line data analysis unit 1052 detects the second feature portion in the second determination area Sa after rotation. The second determination area S is rotated L times. The predetermined number of times L is indicated by the number obtained by dividing 2π by the second predetermined angle 522.

The processing of the movement route prediction unit 106 moves to processing (106F5) of the simulation unit 1063 (see FIG. 19). FIG. 21 is a flowchart of the simulation unit 1063. The processing (106F5) will be described by focusing on the piece of people flow data 50g in the predetermined time frame ta.

The simulation unit 1063 determines whether the piece of people flow data 50g is located within the predetermined range 2222 of the destination 2221 (106F501). Since the piece of people flow data 50g is not located within the predetermined range 2222 of the destination 2221 (106F501: No), the simulation unit 1063 calculates a second objective variable of the piece of people flow data 50g by referring to the parameters 1102(1) to 1102(N) (see FIG. 18) of the flow line prediction model in the flow line prediction model database 110( 106F506).

The second objective variable includes a movement direction 524 and a movement distance 523. The movement direction 524 is, for example, an angle between the reference direction 521 and a straight line connecting the piece of people flow data 50g and the piece of people flow data 50h. The movement distance 523 is a distance between the piece of people flow data 50g and the piece of people flow data 50h.

Returning to FIG. 19, the movement route prediction unit 106 performs processing (106F4 and 106F5) on series of other people flow data 51 other than the series of people flow data 50 (106F6: No). If the processing (106F4 and 106F5) is performed on each series of people flow data 50 (106F6: Yes), the movement route prediction unit 106 advances the time frame ta by one (106F7). As a result, the piece of people flow data 50g and the piece of people flow data 51g move to the piece of people flow data 50h and the piece of people flow data 51h, respectively.

The processing (106F5) of the simulation unit 1063 in a piece of people flow data 50j located in the predetermined range 2222 of the destination 2221 will be described (see FIG. 21). Since the piece of people flow data 50j is located in the predetermined range 2222 of the destination 2221 (106F501: Yes), the simulation unit 1063 determines whether the automatic CI machine 222(1) of the destination 2221 is the stay type (106F502). Since it is determined from the workflow database 109a that the automatic CI machine 222(1) is the stay type (106F502: Yes) (see FIG. 13), the simulation unit 1063 determines whether the series of people flow data 50 stays within the predetermined range 2222 for a certain time or more (106F503). Note that, if the destination is the passing type (106F502: No), the processing moves to processing of selecting a next workflow (106F504), which will be described later.

If the series of people flow data 50 stays within the predetermined range 2222 for the certain time or more (106F503: Yes), the simulation unit 1063 selects the workflow to which the series of people flow data 50 moves next (106F504). Regarding a method of selecting the workflow, the workflow may be selected based on the transition probability 1105 stored in the flow line prediction model database 110. After the processing (106F504) ends, the simulation unit 1063 executes the processing (106F506).

Note that, if the series of people flow data 50 does not stay the certain time or more (106F503: No), the simulation unit 1063 sets the next movement direction 524 and movement distance 523 of the series of people flow data 50 (105F505). The movement direction 524 and the movement distance 523 set in the processing (105F505) are restricted so that the series of people flow data 50 moves to any position coordinates within the predetermined range 2222.

Returning to FIG. 19, the movement route prediction unit 106 determines whether an end condition of the flow line simulation is satisfied (106F8). If the end condition is not satisfied (106F8: No), the processing of the movement route prediction unit 106 returns to the processing (106F2). If the end condition is satisfied (106F8: Yes), the processing of the movement route prediction unit 106 ends. The end condition may be, for example, a condition that the movement ends when each series of people flow data 50 generated by the virtual movement data generation unit 1061 arrives at the gate 225.

According to the present embodiment configured as described above, the movement route prediction system 10 can simulate the flow line of the person 30 in the airport 20 after the layout is changed. The movement route prediction system 10 can improve the accuracy of the flow line simulation by learning the flow line prediction model for each of the first to fifth pieces of divided flow line data 3101 to 3105. As a result, the movement route of the person 30 can be confirmed before the layout is changed, so that costs for changing the layout can be reduced.

The movement route prediction system 10 can find a new checkpoint from the series of flow line data 310 by the workflow analysis unit 104. The movement route prediction system 10 can find a checkpoint that can be deleted in the definition workflows 1031. As a result, the movement route prediction system 10 can prevent failure to set the checkpoints 220.

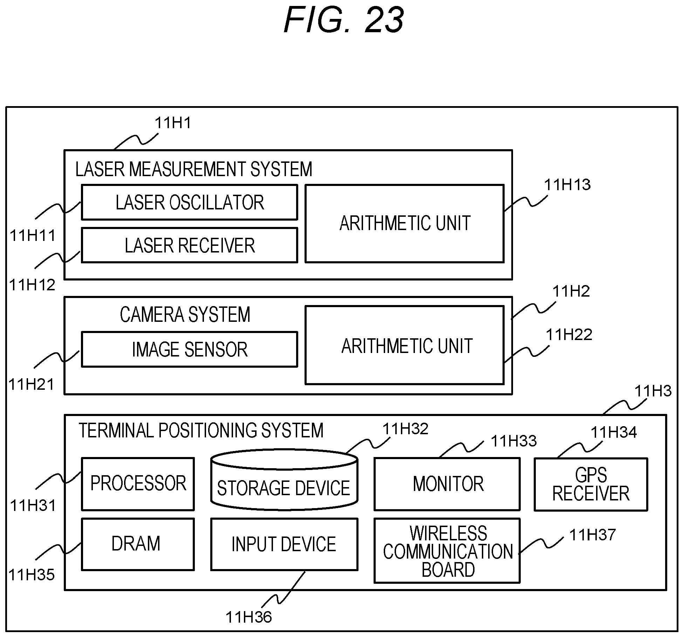

Note that, as illustrated in FIG. 23, the movement measurement system 11 may include any one or more of a laser measurement system 11H1, a camera system 11H2, and a terminal positioning system 11H3.

The laser measurement system 11H1 includes a laser oscillator 11H11 that emits laser light, a laser receiver 11H12 that reads reflected laser light, and an arithmetic unit 11H13. The arithmetic unit 11H13 obtains a plurality of distances to an object around the laser measurement system 11H1 from differences between laser oscillation times and laser reception times. The arithmetic unit 11H13 calculates data of an outer diameter shape and position coordinates of the object from the plurality of calculated distances. The data of the outer diameter shape of the object may be indicated as, for example, point cloud data including a large number of points.

The camera system 11H2 includes an image sensor 11H21 that obtains visible light as an image, and an arithmetic unit 11H22 that detects a person from the image and estimates a position of the person.

The terminal positioning system 11H3 is, for example, a terminal held by the person 30 to transmit position information of the person 30 to the movement route prediction system 10. The terminal positioning system 11H3 includes a processor 11H31 having computing performance, a memory 11H35 that is a volatile temporary storage area, a storage device 11H32 that is a non-volatile storage area, an input device 11H36 that accepts operations by a person, a monitor 11H33 for presenting a current terminal status, a wireless communication board 11H37 that is a network interface card for performing wireless communication, and a GPS receiver 11H34 for specifying a position of the terminal. When the processor 11H31 executes a program recorded in the storage device 11H32, the position information of the person 30 is measured by use of the GPS receiver 11H34 or the like. The measured position information is transmitted to the movement route prediction system 10 via the NIC 11H37.

Note that the present invention is not limited to the configuration of the above-described embodiment, is shown by the scope of the claims, and is intended to include meanings equivalent to the scope of the claims and all modifications within the scope.

### Reference Signs List

- 10: movement route prediction system
- 11: movement measurement system
- 101: measurement data acquisition unit
- 102: map data input unit
- 103: workflow input unit
- 104: workflow analysis unit
- 1041: definition workflow allocation unit
- 1042: difference extraction unit
- 1043: update proposal presentation unit
- 1044: workflow update unit
- 105: flow line prediction model learning unit
- 1051: flow line data division unit
- 1052: flow line data analysis unit
- 1053: machine learning unit
- 106: movement route prediction unit
- 1061: virtual movement data generation unit
- 1062: feature amount calculation unit
- 1063: simulation unit
- 107: flow line database
- 108: layout database
- 109: workflow database
- 110: flow line prediction model database

## Claims

1. A movement route prediction system that predicts a route of a moving body moving within a predetermined area in which a plurality of checkpoints including at least one departure checkpoint, at least one target checkpoint, and at least one intermediate checkpoint is arranged,
the moving body moving within the predetermined area from the departure checkpoint to the target checkpoint via the intermediate checkpoint,
the movement route prediction system comprising:
a measurement data acquisition unit that acquires, from a movement measurement system, information on a movement route of the moving body measured by the movement measurement system;
a map data input unit that acquires position information of the plurality of checkpoints;
a workflow input unit that sets transit information of the plurality of checkpoints where the moving body moves;
a flow line prediction model learning unit that performs machine learning on a flow line prediction model; and
a movement route prediction unit that simulates the route of the moving body based on the flow line prediction model, wherein
the flow line prediction model learning unit includes
a flow line data division unit that divides the information on the movement route into a plurality of divisions, and
a machine learning unit that performs machine learning on the flow line prediction model for each piece of the divided information on the movement route of the moving body.

2. The movement route prediction system according to claim 1, further comprising a workflow analysis unit including
a difference extraction unit that extracts a difference between the information on the movement route and the transit information of the plurality of checkpoints set by the workflow input unit,
an update proposal presentation unit that outputs the extracted difference, and
a workflow update unit that updates the transit information.

3. The movement route prediction system according to claim 2, wherein
the checkpoints are further classified into a passing type attribute and a stay type attribute,
the information on the movement route is a set of pieces of position information in which movement of the moving body is measured at predetermined intervals, and
the workflow analysis unit determines that the moving body has transited the passing type checkpoint when the information on the movement route is located in a vicinity of the passing type checkpoint, and determines that the moving body has transited the stay type checkpoint when a density of the set of pieces of position information is equal to or higher than a certain threshold value within a predetermined range of the stay type checkpoint.

4. The movement route prediction system according to claim 3, wherein the difference extraction unit acquires a high-density range of the predetermined area where the density of the set of pieces of position information is equal to or higher than the certain threshold value, and extracts, as a difference, the high-density range as an addition candidate when the high-density range is separated from the plurality of checkpoints by a predetermined distance or more.

5. The movement route prediction system according to claim 3, wherein the difference extraction unit acquires information on the stay type checkpoint where the density of the set of pieces of position information is equal to or lower than the certain threshold value, and extracts, as a difference, the checkpoint as a candidate for a checkpoint to be deleted.

6. The movement route prediction system according to claim 1, wherein
the flow line prediction model learning unit further includes a flow line data analysis unit, and
the flow line data analysis unit
sets a first determination area having a first predetermined angle in a first predetermined direction of the moving body,
calculates a first feature amount from information on a first feature portion located in the first determination area,
rotates the first determination area around the moving body from the first predetermined direction by each first predetermined angle,
calculates the first feature amount each time the first determination area is rotated, and
calculates a first objective variable from the information on the movement route of the moving body.

7. The movement route prediction system according to claim 3, wherein
the movement route prediction unit includes
a virtual movement data generation unit that generates a virtual moving body at the departure checkpoint, and
a simulation unit that simulates a route of the virtual moving body for each section between the checkpoints by moving the virtual moving body from the departure checkpoint to the target checkpoint via the intermediate checkpoint.

8. The movement route prediction system according to claim 7 wherein
the movement route prediction unit further includes a feature amount calculation unit,
the feature amount calculation unit
sets a second determination area having a second predetermined angle in a second predetermined direction of the virtual moving body,
calculates a second feature amount from information on a second feature portion located in the second determination area,
rotates the second determination area around the virtual moving body from the second predetermined direction by each second predetermined angle, and
calculates the second feature amount each time the second determination area is rotated, and
the simulation unit
calculates a second objective variable from the second feature amount, and
simulates the route of the virtual moving body based on the second objective variable.

9. The movement route prediction stem according to claim 8, wherein
the simulation unit
sets, when the virtual moving body moves to the stay type checkpoint, the second objective variable so that the virtual moving body stays within the predetermined range of the stay type checkpoint, and
sets, when the virtual moving body stays within the predetermined range of the stay type checkpoint for a predetermined time or more, a checkpoint to which the virtual moving body moves next.

10. The transit information is set in the workflow input unit by a user.
The movement route prediction system according to claim 1.

11. A movement route prediction method that is performed by a movement route prediction system and predicts a route of a moving body moving within a predetermined area in which a plurality of checkpoints including at least one departure checkpoint, at least one target checkpoint, and at least one intermediate checkpoint is arranged,
the moving body moving within the predetermined area from the departure checkpoint to the target checkpoint via the intermediate checkpoint,
the movement route prediction method comprising:
acquiring, from a movement measurement system, information on a movement route of the moving body measured by the movement measurement system;
acquiring position information of the plurality of checkpoints;
setting transit information of the plurality of checkpoints where the moving body moves;
dividing the information on the movement route into a plurality of divisions;
performing machine learning on a flow line prediction model for each piece of the divided information on the movement route; and
simulating the route of the moving body based on the flow line prediction model.

12. A computer program for causing a computer to function as a movement route prediction system that predicts a route of a moving body moving in a predetermined area in which a plurality of checkpoints including at least one departure checkpoint, at least one target checkpoint, and at least one intermediate checkpoint is arranged,
the moving body moving within the predetermined area from the departure checkpoint to the target checkpoint via the intermediate checkpoint,
the computer program being for implementing, on the computer, each of:
a measurement data acquisition unit that acquires, from a movement measurement system, information on a movement route of the moving body measured by the movement measurement system;
a map data input unit that acquires position information of the plurality of checkpoints;
a workflow input unit that sets transit information of the plurality of checkpoints where the moving body moves;
a workflow analysis unit that outputs a difference between the information on the movement route of the moving body and the set transit information;
a flow line prediction model learning unit that divides the information on the movement route into a plurality of divisions, and performs machine learning on a flow line prediction model for each piece of the divided information of the movement route; and
a movement route prediction unit that simulates the route of the moving body based on the flow line prediction model.
